# EUROPÄISCHE PATENTSCHRIFT

(11) **EP 0 780 021 B1**
(45) Veröffentlichungstag und Bekanntmachung des Hinweises auf die Patenterteilung: **25.02.1998**
(21) Anmeldenummer: 95929755.7
(22) Anmeldetag: 05.09.1995
(51) Int. Cl.: H01H 11/00, H01H 1/58, H01R 4/02, H01R 9/22

(54) **VERFAHREN ZUR KONTAKTIERUNG VON STARKSTROM-ANSCHLUSSELEMENTEN EINES ELEKTRISCHEN BAUELEMENTES UND UNTER ANWENDUNG DIESES VERFAHRENS HERGESTELLTE BAUGRUPPE**
PROCESS FOR CONTACTING POWER CURRENT CONNECTION ELEMENTS OF AN ELECTRIC COMPONENT AND COMPONENT PRODUCED USING THIS PROCESS
PROCEDE DE MISE EN CONTACT D'ELEMENTS DE RACCORDEMENT POUR COURANT FORT D'UN COMPOSANT ELECTRIQUE ET COMPOSANT FABRIQUE PAR MISE EN OEUVRE DE CE PROCEDE

(30) Priorität: 09.09.1994 DE 4432191
(43) Veröffentlichungstag der Anmeldung: 25.06.1997
(73) Patentinhaber: SIEMENS AKTIENGESELLSCHAFT, 80333 München (DE)
(72) Erfinder: CEPA, Frank, P-7000 Evora (PT); VOJTA, Erich, D-91334 Hemhofen (DE)
(86) Internationale Anmeldenummer: DE9501203
(87) Internationale Veröffentlichungsnummer: WO9608023

(56) Entgegenhaltungen:
- EP-A- 0 312 415
- DE-C- 4 323 827
- DE-U- 8 912 914
- GB-A- 2 029 107
- GB-A- 2 239 827

## Beschreibung

Verfahren zur Kontaktierung von Starkstrom-Anschlußelementen eines elektrischen Bauelementes und unter Anwendung dieses Verfahrens hergestellte Baugruppe

Die Erfindung betrifft ein Verfahren zur Kontaktierung von Starkstrom-Anschlußelementen eines elektrischen Bauelementes an Verbindungsleitern eines isolierenden Trägers, wobei die aus Blech gebildeten Verbindungsleiter in den Kunststoff des Trägers eingebettet sind und mit Verbindungslappen aus der Oberfläche des Trägers hervorragen und wobei flache Anschlußzungen des Bauelementes parallel an den Verbindungslappen anliegend mit diesen verschweißt werden. Außerdem betrifft die Erfindung eine unter Anwendung dieses Verfahrens hergestellte elektrische Baugruppe.

In der Automobiltechnik und auf anderen Gebieten ist es üblich, ein oder mehrere Relais zusammen mit anderen Bauelementen, wie Dioden und Widerständen, auf einer kleinen Leiterplatte zu einer Baugruppe, einem sogenannten Modul, zusammenzufassen, welche mit Flachsteckern versehen ist und dadurch leicht austauschbar ist. Wenn die Bauelemente in einem solchen Modul, insbesondere Relais, hohe Ströme schalten müssen, reichen die geätzten und gedruckten Leiterbahnen herkömmlicher Leiterplatten nicht zum Führen solcher Ströme aus. Für diesen Fall wurde bereits vorgeschlagen, die Verbindungsleiter in Form von Stanzgittern aus Blech herzustellen und in eine als Formteil, beispielsweise durch Spritzgießen, hergestellte Leiterplatte einzubetten. Die Anschlüsse zwischen den Bauelementen und den Verbindungsleitern können dabei über Verbindungslappen hergestellt werden, welche aus der Einbettungsebene in der gespritzten Leiterplatte zu einer Verbindungsseite nach außen gebogen sind, also wenige Millimeter aus der Leiterplatte vorstehen. Da Weichlotverbindungen zwischen diesen Verbindungslappen und den Bauteilanschlüssen wegen der hohen Strombelastung und wegen der dabei erforderlichen, kontaktschädlichen Flußmittel nicht in Betracht kommen, wurde versucht, die Kontaktierung über Schweißverbindungen herzustellen. Da jedoch häufig wenig Platz zur Verfügung steht, können die vorstehenden Verbindungslappen nur sehr kurz sein, also in der Größenordnungen von 2 bis 3 mm. Dies bedeutet, daß die Schweißung in unmittelbarer Nähe des Trägerkunststoffes erfolgen muß. Wenn nun andererseits aus Umweltschutz- und Kostengründen kein temperaturbestandiger Kunststoff für den Träger verwendet wird, bedingen die bisherigen Schweißverfahren eine starke thermische Belastung nicht nur an der Schweißstelle, sondern wegen der hohen Leitfähigkeit auch eine starke thermische Belastung des benachbarten Trägerkunststoffes. Diese Erwärmung führt zu thermischen Schäden im Kunststoff, zu unerwünschten Schichtbildungen auf Kontakten und unter Umständen zur Explosion der Schmelze an der Schweißstelle, wenn der verflüssigte Kunststoff dorthin gelangt.

Aufgabe der vorliegenden Erfindung ist es, ein Verfahren zur Schweißkontaktierung von Starkstrom-Anschlußelementen eines elektrischen Bauelementes sowie eine mit diesem Verfahren herstellbare Baugruppe anzugeben, wobei die Fügeabschnitte der Verbindungsleiter des Baugruppenträgers einerseits und der Anschlußzungen des Bauelementes andererseits so gestaltet sind, daß die Schweißverbindung in unmittelbarer Nähe des Kunststoffträgers in zufriedenstellender Weise hergestellt und zugleich eine übermäßige thermische Belastung des benachbarten Kunststoffträgers vermieden werden kann.

Erfindungsgemäß wird dies mit einem Verfahren der eingangs genannten Art dadurch erreicht, daß an den Verbindungslappen und den Anschlußzungen durch Materialausnehmungen eine Zahnkontur mit einem oder mehreren Zähnen ausgebildet wird, deren Querschnitt derart bemessen ist, daß eine über eine bestimmte Zeitdauer einwirkende, vorgegebene Schweißenergie zwar die aufeinanderliegenden Zähne der Verbindungslappen und der Anschlußzungen verschweißt, die Wärmeleitung über die Zähne zum Träger jedoch kein Aufschmelzen des Trägerkunststoffes bewirkt.

Die Schweißenergie wird zweckmäßigerweise durch Laserschweißen, Plasmaschweißen oder vorzugsweise durch ein Lichtbogen-Schutzgas-Schweißverfahren aufgebracht. Beim Lichtbogenschweißen ist es weiterhin zweckmäßig, daß mittels zweier Elektrodenbacken zur Kontaktierung der zu verschweißenden Zähne zugleich eine Wärmeableitung vorgenommen wird. Außerdem kann es zweckmäßig sein, beim Schweißvorgang zusätzlich den Trägerkunststoff durch eine Maske abzuschirmen, welche im Bereich der Anschlußzungen und Verbindungslappen jeweils Aussparungen aufweist.

Eine mit dem erfindungsgemäßen Verfahren herstellbare Baugruppe besitzt einen aus Kunststoff bestehenden Träger, ferner in den Träger eingebettete, aus elektrisch gut leitendem Metallblech, wie. Kupfer oder einer Kupferlegierung, bestehenden Verbindungsleiter, von denen jeweils Verbindungslappen aus einer Trägeroberfläche nach außen ragen, und mindestens ein auf dem Träger befestigtes Bauelement, insbesondere ein oder mehrere Relais, dessen bzw. deren Anschlußelemente in Form von flachen Anschlußzungen flach auf den Verbindungslappen aufliegend mit diesen verschweißt sind, und erfindungsgemäß weisen dabei die aufeinanderliegenden Endabschnitte der Verbindungslappen und der Anschlußzungen jeweils eine Zahnkontur mit einem oder mehreren Zähnen auf, wobei die jeweils aufeinanderliegenden Zähne verschweißt sind.

In bevorzugter Ausführungsform ist dabei der Träger als Leiterplatte in einer oder in zwei zueinander senkrechten Ebenen aus Kunststoff geformt, in welche die Verbindungsleiter in Form eines oder mehrerer Stanzgitter eingebettet sind, wobei die von den Verbindungsleitern im rechten Winkel zur Leiterplattenebene abgebogenen Verbindungslappen nach außen zu einer Verbindungsseite geführt und jeweils unmittelbar neben den Verbindungslappen in der Leiterplatte Stecköffnungen ausgespart sind; ein oder mehrere, mit Flachsteckern versehene Bauelemente, insbesondere Relais, sind dabei auf einer der Verbindungsseite gegenüberliegenden Bauteileseite der Leiterplatte angeordnet, wobei die Flachstecker der Bauelemente durch die Stecköffnungen gesteckt und auf der Verbindungsseite mit den Verbindungslappen verschweißt sind.

Die Erfindung wird nachfolgend an Ausführungsbeispielen anhand der Zeichnung näher erläutert. Es zeigen
Figur 1 ein mit drei verschiedenen Relais bestücktes Relaismodul mit Schweißkontaktierungen gemäß der Erfindung,
Figur 2 und 3 eine Anordnung zur Schweißkontaktierung in zwei schematischen Ansichten und
Figuren 4 bis 6 verschiedene mögliche Zahngestaltungen für die zur Kontaktierung vorgesehenen Fügeabschnitte.

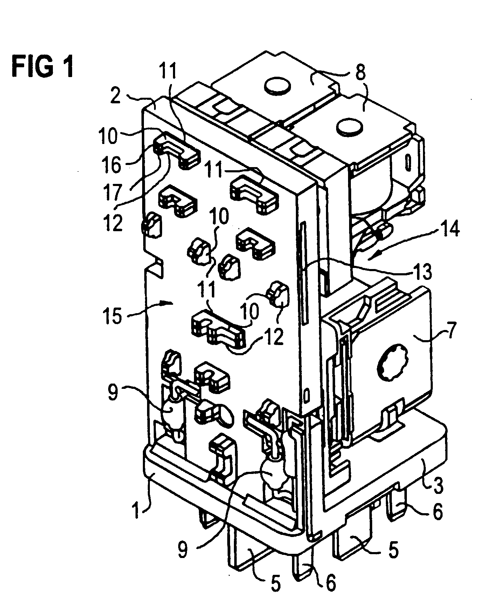

Figur 1 zeigt eine Baugruppe, ein sogenanntes Relaismodul, bestehend aus einer aus Kunststoff gespritzten Leiterplatte 1 mit L-förmigem Querschnitt, wobei ein senkrechter Schenkel als eigentlicher Leiterplattenschenkel 2 zur Aufnahme von Bauelementen dient, während ein waagerechter Schenkel als Sockel 3 dient, der zusammen mit einer nicht gezeigten Kappe ein geschlossenes Gehäuse bildet. Aus dem Sockel treten nach unten Stecker unterschiedlichen Querschnitts aus, nämlich breite Flachstecker 5 mit großem Querschnitt und schmälere Flachstecker 6 mit geringerem Querschnitt.

Die Baugruppe enthält bei diesem Beispiel drei Relais, nämlich ein größeres Relais 7 sowie zwei kleinere Relais 8, außerdem kleinere Bauelemente 9, beispielsweise Widerstände oder Dioden. Die Relais 7 bzw. 8 sind mit Flachsteckern bzw. Anschlußzungen 10 in Stecköffnungen 11 der Leiterplatte 1 eingesteckt und an der Rückseite mit Verbindungslappen 12 von Verbindungsleitern 13 verschweißt. Diese Verbindungsleiter stellen als Leiterbahnen die elektrischen Verbindungen zwischen den Anschlußstiften der Relais 7 und 8 sowie der übrigen Bauteile 9 untereinander und zu den Flachsteckern 5 und 6 her. Sie sind zur Führung hoher Ströme aus relativ dickem Blech eines gut leitenden Metalls, beispielsweise Kupfer oder einer Kupferlegierung, gestanzt und in einer oder mehreren Ebenen - mit Abwinkelungen und Abkröpfungen - in die Leiterplatte 1 eingebettet. Die Blechstärke der Verbindungsleiter beträgt dabei typischerweise zwischen 0,5 und 1,5 mm. Die Relais 7 und 8 befinden sich in einem durch die Schenkel 2 und 3 der Leiterplatte 1 auf zwei Seiten umgrenzten Bauteileraum 14, während die erwähnten Verbindungslappen 12 aus der Umspritzung nach außen zu einer Verbindungsseite 15 des Leiterplattenschenkels 2 rechtwinkelig abgebogen sind, so daß sie mit einer geringen Höhe, typischerweise zwischen 2 und 3 mm, aus dem Kunststoff vorstehen. Die ebenfalls erwähnten Stecköffnungen 11 befinden sich unmittelbar neben den abgebogenen Verbindungslappen 12, so daß die Anschlußzungen 10 nach dem Einstecken der Relais 7 und 8 unmittelbar parallel an den Verbindungszungen 12 anliegen.

Wie aus Figur 1 weiter zu ersehen ist, sind die Anschlußzungen 10 der Relais und die Verbindungslappen 12 der Verbindungsleiter jeweils in ihren Endbereichen durch entsprechende Ausnehmungen zu einer Zahnkontur gestaltet, wobei je nach der geforderten Strombelastung für den betreffenden Anschluß ein, zwei oder auch mehrere Zähne 16 bzw. 17 an den Anschlußzungen bzw. den Verbindungslappen ausgebildet sein können. Diese Zähne 16 und 17 liegen jeweils deckungsgleich aufeinander und bilden so einzelne Schweißstellen, deren Leiterquerschnitt jeweils wesentlich geringer ist als der Gesamtquerschnitt der Verbindungslappen bzw. der Anschlußzungen. Dadurch erreicht man, wie bereits ausgeführt, daß bei einem vorgegebenen Schweißstrom diese Zähne aufgrund des durch die Querschnittsverengung bewirkten Wärmestaus wesentlich schneller die Schmelzphase erreichen als bei vollem Materialquerschnitt. Zugleich wird die Wärme aber auch über den geringeren Querschnitt wesentlich langsamer zu den Verbindungslappen selbst und zum Trägerkunststoff der Leiterplatte 1 weitergeleitet, so daß eine überhöhte Wärmebelastung des Kunststoffs durch entsprechende Abstimmung des Zahnquerschnittes und der Einwirkdauer der Schweißenergie vermieden werden kann. Falls der Leitungsquerschnitt einer einzigen Zahn-Schweißstelle für die geplante Strombelastung des betreffenden Anschlusses nicht ausreicht, können entsprechend mehrere Zähne und damit mehrere Schweißstellen vorgesehen werden, die dann insgesamt den erforderlichen Strom zu führen vermögen. Da jeder Zahn einzeln geschweißt wird, verteilt sich somit die Wärmebelastung des Schweißens auf mehrere Einzelschweißungen, so daß bei entsprechender Abstimmung nie die zulässige Wärmebelastung für den in der Nähe befindlichen Kunststoff überschritten wird.

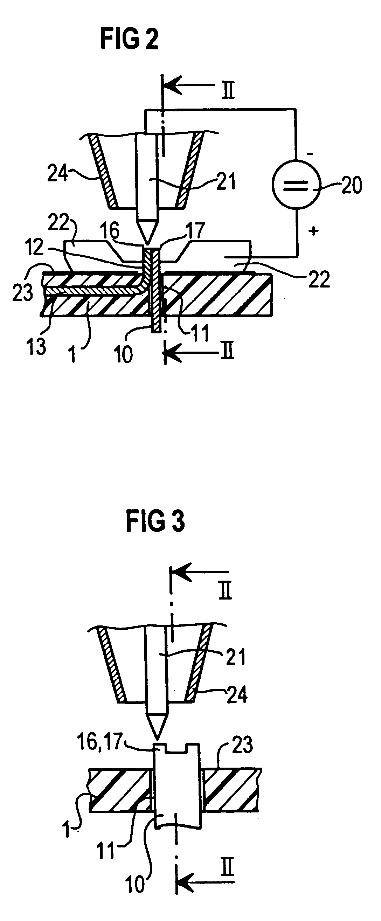

In den Figuren 2 und 3 ist schematisch in zwei Ansichten eine Schweißanordnung mit einer WIG-Schweißvorrichtung gezeigt, wie sie für die Erfindung bevorzugt zum Einsatz kommt. In dem isolierenden Träger der Leiterplatte 1 ist der Verbindungsleiter 13 als Leiterplatte eingebettet, wobei für einen Relaisanschluß ein Verbindungslappen 12 senkrecht abgebogen ist, so daß er wenige Millimeter aus dem Kunststoff vorsteht. Neben dem Verbindungslappen 12 ist im Träger 1 eine durchgehende Stecköffnung 11 ausgespart, durch die eine Anschlußzunge 10 eines Relais gesteckt wird. Das Ende der Anschlußzunge 10 liegt parallel an dem Verbindungslappen 12 an. Wie aus Figur 3 zu ersehen ist, besitzen der Verbindungslappen 12 und die Anschlußzunge 10 jeweils zwei freigestanzte Zähne 16 bzw. 17. Zum Lichtbogenschweißen wird nun eine Elektrode 21, die mit der Kathode einer Schweißstromquelle 20 verbunden ist, über einem Zahnpaar 16 und 17 mit geringem Abstand angeordnet, während die Anode mit Schweißbacken 22 verbunden ist, welche den Verbindungslappen 12 und die Anschlußzunge 10 beim Schweißen aneinanderpressen. Diese Schweißbacken 22 können aus hochwärmeleitfähigem Material bestehen und dadurch als Kühlelemente zusätzlich Wärme abführen. Zusätzlich kann ein Abschirmblech 23, welches im Bereich der Verbindungslappen und der Anschlußfahnen Aussparungen besitzt, die Oberfläche des Kunststoffträgers abschirmen. Die Schweißelektrode 21 ist außerdem von einer Düse 24 umschlossen, durch die Schutzgas, beispielsweise Argon, während des Schweißens auf die Schweißstelle geblasen wird.

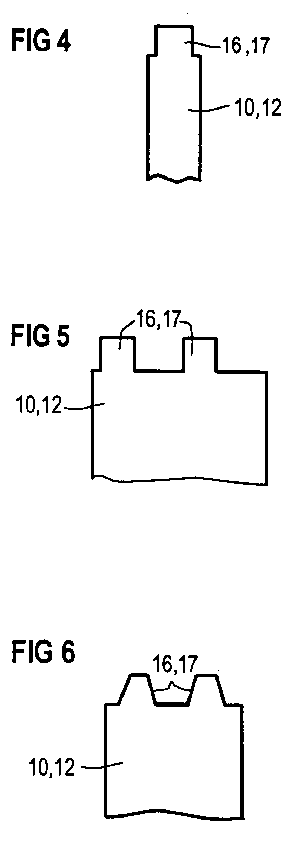

In den Figuren 4 bis 6 sind einige mögliche Zahnkonturen gezeigt, wie sie für die Erfindung in Betracht kommen. So zeigt Figur 4 einen Verbindungslappen 12 mit einem Zahn 17 mit einer Rechteckkontur, Figur 5 einen entsprechend breiteren Verbindungslappen 12 mit zwei Zähnen 17, ebenfalls in Rechteckkontur. Figur 6 zeigt entsprechende Zähne 27 mit einer Trapezkontur. Es sind aber auch dreieckförmige oder beliebige andere Konturen denkbar. Wichtig ist lediglich, daß die Zähne jeweils bei einer vorgegebenen kurzen Schweißdauer von beispielsweise 100 ms verschweißen und dabei den erforderlichen Stromübergang für das betreffende Bauteil gewährleisten, ohne daß die Wärmeleitung der Schweißenergie zum Trägerkunststoff letzteren zum Schmelzen bringt. Wie erwähnt, wird durch die Anzahl der Zähne der Gesamt-Leiterquerschnitt für den Anschluß vervielfacht, wobei jedoch jeweils nur die Schweißenergiebelastung der einzelnen Zähne zeitlich versetzt zur Geltung kommt.

## Patentansprüche

1. Verfahren zur Kontaktierung von Starkstrom-Anschlußelementen eines elektrischen Bauelementes an Verbindungsleitern eines isolierenden Trägers, wobei die aus Blech gebildeten Verbindungsleiter (13) in den Kunststoff des Trägers (1) eingebettet sind und mit Verbindungslappen (12) aus der Oberfläche des Trägers hervorragen und wobei flache Anschlußzungen (10) des Bauelementes (7, 8) parallel an den Verbindungslappen (12) anliegend mit diesen verschweißt werden, **dadurch gekennzeichnet**, daß an den Verbindungslappen (12) und den Anschlußzungen (10) durch Materialausnehmungen eine Zahnkontur mit einem oder mehreren Zähnen (16, 17) ausgebildet wird, deren Querschnitt derart bemessen ist, daß eine über eine bestimmte Zeitdauer einwirkende, vorgegebene Schweißenergie zwar die aufeinanderliegenden Zähne (16, 17) der Verbindungslappen (12) und der Anschlußzungen (10) verschweißt, die Wärmeleitung über die Zähne (16, 17) zum Träger (1) jedoch kein Aufschmelzen des Trägerkunststoffes bewirkt.

2. Verfahren nach Anspruch 1, **dadurch gekennzeichnet,** daß die Schweißenergie durch Laserschweißen, Plasmaschweißen oder vorzugsweise durch Lichtbogen-Schutzgas-Schweißen (WIG-Schweißen) aufgebracht wird.

3. Verfahren nach Anspruch 2, **dadurch gekennzeichnet,** daß beim Lichtbogenschweißen über Elektrodenbacken (22), welche die zu verschweißenden Zähne (16, 17) kontaktieren, eine Wärmeableitung erfolgt.

4. Verfahren nach einem der Ansprüche 1 bis 3, **dadurch gekennzeichnet,** daß der Trägerkunststoff während des Schweißvorgangs zusätzlich durch eine Maske (23) abgeschirmt wird, welche im Bereich der Anschlußzungen (10) und Verbindungslappen (12) jeweils Aussparungen aufweist.

5. Baugruppe mit einem aus Kunststoff bestehenden Träger (1), mit in dem Träger eingebetteten, aus elektrisch gut leitendem Materialblech bestehenden Verbindungsleitern (13), von denen jeweils Verbindungslappen (12) aus einer Trägeroberfläche (15) nach außen ragen, und mit mindestens einem auf dem Träger (1) befestigten Bauelement (7, 8), dessen Anschlußelemente in Form von flachen Anschlußzungen (10) flach auf den Verbindungslappen (12) aufliegend mit diesen verschweißt sind, **dadurch gekennzeichnet,** daß die aufeinanderliegenden Endabschnitte der Verbindungslappen (12) und der Anschußzungen (10) jeweils eine Zahnkontur mit einem oder mehreren Zähnen (16, 17) aufweisen und daß die aufeinanderliegenden Zähne (16, 17) verschweißt sind.

6. Baugruppe nach Anspruch 5, **dadurch gekennzeichnet**, daß der Träger als Leiterplatte (1) aus Kunststoff geformt ist, in welche die Verbindungsleiter (13) in Form eines oder mehreren Stanzgitter eingebettet sind,
daß die von den Verbindungsleitern (13) im rechten Winkel zur Leiterplattenebene abgebogenen Verbindungslappen (12) nach außen zu einer Verbindungsseite (15) geführt sind,
daß in der Leiterplatte (1) jeweils unmittelbar neben den Verbindungslappen (12) Stecköffnungen (11) ausgespart sind,
daß ein oder mehrere mit Flachsteckern versehene Bauelemente (7, 8), insbesondere Relais, auf einer der Verbindungsseite (15) gegenüberliegenden Bauteileseite (14) der Leiterplatte (1) angeordnet und
daß die Flachstecker der Bauelemente als Anschlußzungen (10) durch die Stecköffnungen (11) gesteckt und auf der Verbindungsseite (15) mit den Verbindungslappen (12) verschweißt sind.

## Claims

1. Method for making contact from heavy-current connecting elements of an electrical component to connecting conductors of an insulating mount, the connecting conductors (13), which are formed from sheet metal, being embedded in the plastic of the mount (1) and projecting with connecting tabs (12) from the surface of the mount, and flat connecting tongues (10) of the component (7, 8), resting parallel on the connecting tabs, being welded to them, characterized in that a tooth contour having one or more teeth (16, 17) is formed on the connecting tabs (12) and the connecting tongues (10) by means of material apertures, the cross section of which teeth is dimensioned in such a manner that, although a predetermined amount of welding energy which acts for a specific time duration admittedly welds the teeth (16, 17) which lie on one another of the welding tabs (17) and of the connecting tongues (10), the thermal conduction via the teeth (16, 17) to the mount (1) does not melt the mount plastic.

2. Method as claimed in Claim 1, characterized in that the welding energy is applied by laser welding, plasma welding or, preferably, by protected arc welding (TIG welding).

3. Method as claimed in Claim 2, characterized in that heat dissipation takes place during arc welding via electrode jaws (22) which make contact with the teeth (16, 17) to be welded.

4. Method as claimed in one of Claims 1 to 3, characterized in that the mount plastic is additionally screened by a mask (23) during the welding process, which mask (23) has cutouts in each case in the region of the connecting tongues (10) and connecting tabs (12).

5. Assembly having a mount (1) which is composed of plastic, having connecting conductors (13) which are embedded in the mount and are composed of electrically highly conductive sheet-metal material, from which connecting conductors (13) connecting tabs (12) in each case project outwards from a mount surface (15), and having at least one component (7, 8) which is mounted on the mount (1) and whose connecting elements, in the form of flat connecting tongues (10) are welded to the connecting tabs (12), such that they rest flat on them, characterized in that those end sections of the connecting tabs (12) and of the connecting tongues (10) which rest on one another in each case have a tooth contour having one or more teeth (16, 17), and in that the teeth (16, 17) which rest on one another are welded.

6. Assembly as claimed in Claim 5, characterized in that the mount is formed as a printed circuit board (1) composed of plastic, into which the connecting conductors (13) are embedded in the form of one or more stamped grids,
in that the connecting tabs (12) which are bent from the connecting conductors (13) at right angles to the printed circuit board plane are passed outwards to a connecting side (15),
in that plug-in openings (11) are cut out in the printed circuit board (1) in each case directly alongside the connecting tabs (12),
in that one or more components (7, 8), in particular relays, which are provided with blade terminals, are arranged on a component side (14), which is opposite the connection side (15), of the printed circuit board (1), and
in that the blade terminals of the components are inserted through the plug-in openings (11) as connecting tongues (10) and are welded to the connecting tabs (12) on the connection side (15).

## Revendications

1. Procédé de mise en contact d'éléments de raccordement pour courant fort d'un composant électrique à des conducteurs de connexion d'un support isolant, les conducteurs de connexion (13) formés de tôle étant noyés dans la matière plastique du support (1) et dépassant de la surface du support par des pattes de raccordement (12) et des languettes de raccordement (10) plates du composant (7, 8) étant soudées aux pattes de raccordement (12) de façon à être posées paralèlement contre celles-ci, caractérisé en ce que les pattes de raccordement (12) et les languettes de raccordement (10) sont pourvues, grâce à des évidements de matière, d'un contour denté présentant une ou plusieurs dent/s (16, 17) dont la section transversale est dimensionnée de manière à ce qu'une énergie de soudage prédéterminée agissant pendant une durée déterminée soude bien les dents superposées (16, 17) des pattes de raccordement (12) et des languettes de raccordement (10) mais que la conduction de chaleur vers le support (1) par le biais des dents (16, 17) ne provoque pas la fonte de la matière plastique du support.

2. Procédé selon la revendication 1, caractérisé en ce que l'énergie de soudage est appliquée par soudage au laser, soudage à l'arc de plasma ou, de préférence, par soudage à l'arc sous protection gazeuse (soudage à l'arc TIG).

3. Procédé selon la revendication 2, caractérisé en ce que, lors du soudage à l'arc, une dissipation de chaleur se produit par le biais de mâchoires d'électrodes (22) qui mettent en contact les dents (16, 17) à souder.

4. Procédé selon l'une des revendications 1 à 3, caractérisé en ce que, pendant le processus de soudage, la matière plastique du support est protégée, en plus, par un masque 23 qui est pourvu, à chaque fois, d'évidements dans la région des languettes de raccordement (10) et des pattes de raccordement (12).

5. Composant comprenant un support (1) formé de matière plastique, comprenant des conducteurs de connexion (13) formés d'une tôle faite d'un matériau conduisant bien le courant électrique et noyés dans le support, et dont des pattes de raccordement (12) font saillie à chaque fois vers l'extérieur sur une surface (15) du support, et comprenant au moins un composant (7, 8) fixé sur le support (1) et dont les éléments de raccordement, se présentant sous forme de languettes de raccordement (10) plates, sont soudées aux pattes de raccordement (12) de façon à être posées à plat sur celles-ci, caractérisé en ce que les segments d'extrémité superposés des pattes de raccordement (12) et des languettes de raccordement (10) sont pourvus, à chaque fois, d'un contour denté présentant une ou plusieurs dent/s (16, 17) et en ce que les dents superposées (16, 17) sont soudées.

6. Composant selon la revendication 5, caractérisé en ce que le support est formé en tant que plaquette (1) en matière plastique dans laquelle les conducteurs de connexion (13) sont noyés sous forme d'une ou plusieurs grille/s estampée/s,
en ce que les pattes de raccordement (12) pliées à partir des conducteurs de connexion (13) à angle droit par rapport au plan de la plaquette sont dirigées vers l'extérieur en direction d'une face de raccordement (15),
en ce que des ouvertures d'enfichage (11) sont ménagées dans la plaquette (1) à chaque fois au voisinage direct des pattes de raccordement (12),
en ce qu'un ou plusieurs composant/s (7, 8) pourvu/s de fiches plates, notamment des relais, est/sont situé/s sur une face à composants (14) de la plaquette (1) située sur le côté opposé de la face de raccordement (15), et
en ce que les fiches plates des composants sont enfoncées, en tant que languettes de raccordement (10), à travers les ouvertures d'enfichage (11) et soudées avec les pattes de raccordement (12) sur la face de raccordement (15).
